# DEMANDE DE BREVET EUROPEEN

(11) **EP 1 351 315 A2**
(43) Date de publication de la demande: **08.10.2003**
(21) Numéro de dépôt: 03100542.4
(22) Date de dépôt: 05.03.2003
(51) Int. Cl.: H01L 29/92, H01L 21/02

(54) **Micro-composant électronique intégrant une structure capacitive, et procédé de fabrication**

(30) Priorité: 20.03.2002 FR 0203442; 20.03.2002 FR 0203445
(71) Demandeur: Memscap, 38190 Bernin (FR)
(72) Inventeur: Girardie, Lionel, 38320, EYBENS (FR)
(74) Mandataire: Palix, Stéphane

(57) **Abrégé**

Micro-composant électronique réalisé à partir d'un substrat, et intégrant une structure capacitive réalisée au-dessus d'un niveau de métallisation (3) présent dans le substrat (2), ladite structure capacitive comportant deux électrodes (4,7), caractérisé en ce que:
- la première électrode (4) comporte une pluralité de lamelles métalliques (14,24,34) empilées les unes au-dessus des autres, et séparées les unes des autres par des tronçons (18,28) de moindre largeur réalisés à partir du même métal,
- la seconde électrode (7) recouvre la première électrode (4) en comportant une pluralité de lamelles (31,32) intercalées entre les lamelles (14,24,34) de la première électrode (4).

## Description

### Domaine technique

L'invention se rattache au domaine technique de la micro-électronique. Elle vise plus précisément des micro-composants électroniques incorporant une ou plusieurs structures capacitives

Ces structures capacitives peuvent former des micro-condensateurs. Ces micro-condensateurs sont alors destinés à être réalisés selon des techniques dites de post-processing, signifiant que ces micro-condensateurs peuvent être réalisés sur la face supérieure de micro-composants existants. Ces composants peuvent être notamment utilisés dans le cadre d'applications radiofréquences, les micro-condensateurs pouvant être par exemple utilisés en tant que capacité de découplage.

Ces structures capacitives peuvent également être destinées à être réalisées à l'intérieur même du micro-composant, au-dessus de niveaux de métallisation directement reliés aux bornes des transistors et autres structures semi-conductrices. Ces structures capacitives peuvent être alors notamment utilisées en tant que cellule de mémoire dynamique embarquée (embedded DRAM).

L'invention vise plus précisément la structure d'une telle capacité en vue d'en augmenter très fortement sa "capacitance", c'est-à-dire sa capacité par unité de surface, et ce sans augmenter trop fortement ni les coûts de fabrication, ni la surface utilisée sur le micro-composant.

### Techniques antérieures

La réalisation de micro-condensateurs ou de structures capacitives sur des substrats semi-conducteurs a déjà fait l'objet de certains développements.

Différentes technologies ont déjà été proposées, notamment celles qui permettent de réaliser des structures capacitives constituées de deux électrodes formées par des couches métalliques, séparées par une couche de matériau isolant ou diélectrique. Ce type de capacité est généralement qualifié de structure "MIM", pour "Métal Isolant Métal". L'invention se rattache plus particulièrement à ce type de structure capacitive.

Parmi les solutions existantes, celle décrite dans le document FR 2 801 425 concerne un micro-condensateur dont les deux électrodes sont formées par des couches métalliques planes. Dans ce cas, la valeur de la capacité du condensateur est essentiellement fonction du type de matériau diélectrique utilisé, ainsi que de la surface en regard des deux électrodes métalliques. Autrement dit, la "capacitance", ou la capacité par unité de surface, est fixée de façon prépondérante par l'épaisseur de la couche isolante et sa permittivité relative. Ainsi, pour augmenter la valeur de capacitance, il est nécessaire soit de choisir des matériaux de très forte permittivité relative, soit de réduire les distances entre les électrodes, avec le risque d'apparition de phénomènes de claquage, voire d'effets tunnel. Autrement dit, les condensateurs réalisés selon la structure décrite dans ce document sont limités en terme de capacitance.

Le Déposant a décrit dans la demande de brevet français No. 02.01618, une nouvelle structure de capacité réalisée sur un niveau de métallisation d'un composant électronique. Chaque électrode de cette structure capacitive comporte une pluralité de lamelles métalliques qui sont perpendiculaires au plan principal du substrat.

Le Déposant a également décrit dans la demande de brevet français No. 02.02461, une autre structure de capacité comportant un empilement de lamelles métalliques superposées, et décalées les unes par rapport aux autres, les parties en contact formant un tronc commun.

Un des objectifs de l'invention est de proposer une structure capacitive qui puisse être réalisée sur le dernier niveau de métallisation apparent d'un micro-composant électronique, et qui possède une valeur de capacitance supérieure aux valeurs habituellement observées.

### Exposé de l'invention

L'invention concerne donc un micro-composant électronique réalisé à base d'un substrat, et intégrant une structure capacitive réalisée au-dessus d'un niveau de métallisation apparent présent sur le substrat. La structure capacitive comporte deux électrodes et se caractérise en ce que :
- la première électrode comporte une pluralité de lamelles métalliques empilées les unes au-dessus des autres, et séparées les unes des autres par des tronçons de moindre largeur réalisés à partir du même métal, formant avec les portions des lamelles métalliques qui les recouvrent un tronc central,
- la seconde électrode recouvre la première électrode en comportant une pluralité de lamelles intercalées entre les lamelles de la première électrode.

Autrement dit, la première électrode forme une structure arborescente comportant un tronc à partir duquel s'étendent des lamelles situées de chaque coté. Le tronc est formé par la superposition des parties centrales des lamelles ainsi que des tronçons de moindre largeur.

La seconde électrode recouvre la première en formant une pluralité de lamelles qui sont intercalées entre les extrémités des lamelles de la première électrode. La surface en regard de chacune des électrodes est donc particulièrement élevée.

Pour une même surface occupée sur le substrat, cette surface en regard peut être accrue en augmentant le nombre de lamelles de chaque électrode, ce qui permet donc d'augmenter la capacitance à souhait.

En pratique, les capacités conformes à l'invention présentent d'excellentes propriétés électriques et notamment lorsque l'on utilise des métaux de très forte conductivité, présentant une résistivité inférieure à 5 µΩ.cm. Les avantages d'une très faible résistivité se traduisent notamment par un faible échauffement de la structure capacitive en mode dynamique, ainsi qu'un bon fonctionnement à haute fréquence, et une conductivité thermique appréciable.

En pratique, les électrodes sont séparées par une couche diélectrique réalisée à partir de matériaux qui sont avantageusement choisis dans le groupe des oxydes ferroélectriques et/ou pyroélectriques. Parmi ces oxydes ferroélectriques, on connaît le dioxyde d'Hafnium, le pentoxyde de Tantale, le dioxyde de Zirconium, les oxydes de Lanthane, le trioxyde de di-Yttrium, l'alumine, le dioxyde de Titane, ainsi que les titanates et tantalates de Strontium (STO), les titanates de Strontium et Baryum (BST), les Tantalates de Strontium et Bismuth (SBT), ainsi que les titanates de Plomb et de zirconates de Plomb (PZT) , les titanates et zirconates de Plomb dopées avec des terres rares (Lanthanides) (PLZT), les nobiates de Strontium et Bismuth (SBN), les tantalates et nobiates de Strontium et Bismuth (SBTN), les cuprates de Baryum et Yttrium, les Alcalinoxydes de Manganèse Me₂MnO₃.

Ce matériau diélectrique peut être déposé soit en couche homogène d'un même matériau, ou d'un alliage de plusieurs de ces matériaux.

Néanmoins, dans une forme préférée, la couche diélectrique peut également être constituée de la superposition de couches élémentaires de matériaux différents formant une structure nanolaminée. Dans ce cas, chacune des couches est de très faible épaisseur, de l'ordre de quelques Angströms à quelques centaines d'Angströms.

Dans une forme préférée, la stoechiométrie des matériaux varie d'une couche élémentaire à l'autre dans la structure nanolaminée. Ainsi, en faisant varier la stoechiométrie de chaque couche, on crée des gradients de concentration d'oxygène (et des autres matériaux utilisés) à travers quelques couches atomiques. La variation de structure de bande de chaque couche élémentaire de la structure nanolaminée a pour conséquence de modifier la structure de bande globale des alliages et des composés d'oxydes ferro et pyroélectriques à travers seulement quelques couches atomiques.

On obtient de la sorte des valeurs de permittivité relative particulièrement importantes, ce qui agit en faveur de l'augmentation de la capacitance.

En pratique, on préfère que la surface de chaque électrode soit recouverte d'une couche de matériau barrière à la diffusion de l'oxygène, typiquement à base de nitrure de titane, de nitrure de tungstène, de nitrure de tantale, ou bien encore l'un des matériaux suivants : TaAlN, TiAlN, Mo, MoN, W, Os, Rh, Re, Ru, CoW ou TaSiN, TiSiₓ, WSiₓ des alliages des métaux de transition avec du bore, du type TiB₂, ou du carbone, du type TiC, selon l'application souhaitée.

L'invention concerne également des procédés de fabrication d'une telle structure capacitive. Cette structure capacitive est fabriquée sur un micro-composant électronique, au-dessus du dernier niveau de métallisation apparent réalisé dans le substrat.

Conformément à un premier mode d'exécution de l'invention, le procédé comporte les étapes suivantes consistant à :
- déposer au-dessus du niveau de métallisation une première couche métallique destinée à former la partie basse d'une des deux électrodes de la structure capacitive,
- déposer au-dessus de ladite première couche métallique une seconde couche métallique de moindre largeur,
- déposer au-dessus de deux couches métalliques une couche de matériau polymère où la face supérieure est apte à servir de support à un dépôt métallique ultérieur,
- répéter les trois étapes de dépôt précédentes de manière à obtenir une structure arborescente formant la première électrode comportant un tronc central et une pluralité de lamelles s'étendant à partir dudit tronc central,
- éliminer l'ensemble des couches de matériau polymère,
- déposer sur toute la surface apparente de la première électrode un matériau diélectrique sous forme d'une structure nanolaminée,
- déposer par-dessus la première électrode un matériau conducteur venant s'insérer entre les couches métalliques de la première électrode, de manière à former la seconde électrode.

Conformément à un second mode d'exécution de l'invention, le procédé comporte les étapes suivantes consistant à :
- déposer au-dessus du niveau de métallisation une première couche métallique destinée à former la partie basse d'une des deux électrodes de la structure capacitive,
- déposer au-dessus de la couche métallique une couche de matériau polymère dont la face supérieure est apte à servir de support à un dépôt métallique ultérieur,
- répéter les deux étapes de dépôt précédentes de manière à obtenir un empilement de couches métalliques séparées par une couche de matériau polymère,
- réaliser au centre de l'empilement une tranchée creusée jusqu'à faire apparaître la première couche métallique,
- déposer dans ladite tranchée un métal identique à celui des couches empilées, de manière à obtenir une structure arborescente formant la première électrode comportant un tronc central et une pluralité de lamelles s'étendant à partir dudit tronc central,
- éliminer l'ensemble des couches de matériau polymère,
- déposer sur toute la surface apparente de la première électrode un matériau diélectrique sous forme d'une structure nanolaminée,
- déposer par-dessus la première électrode un matériau conducteur venant s'insérer entre les couches métalliques de la première électrode, de manière à former la seconde électrode.

### Description sommaire des figures

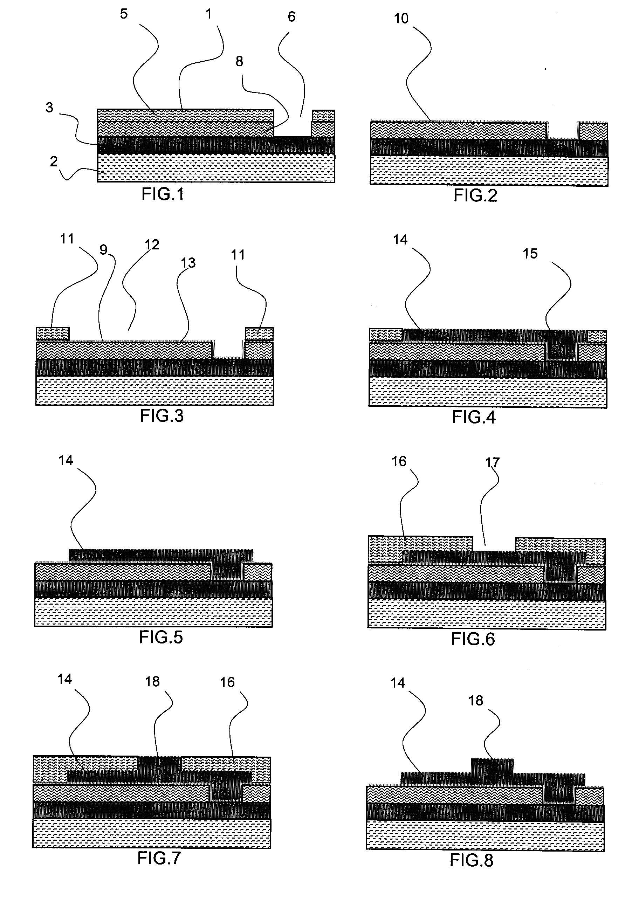

La manière de réaliser l'invention ainsi que les avantages qui en découlent ressortiront bien de la description des modes de réalisation qui suit, à l'appui des figures 1 à 27 annexées, qui sont des représentations schématiques en coupe de la zone supérieure d'un micro-composant électronique, et de la structure capacitive conforme à l'invention, au fur et à mesure des étapes des procédés de réalisation. Plus précisément, les figures 1 à 5 et 13 à 18 sont des vues communes aux deux procédés décrits en détails. Les figures 6 à 12 d'une part, et 19 à 27 d'autre part, sont propres à un mode de réalisation particulier.

Bien entendu, ces schémas ne sont donnés qu'à titre illustratif, et les dimensions des différentes couches et éléments réels intervenant dans l'invention peuvent différer de celles qui sont représentées aux figures, uniquement dans le but de faire comprendre l'invention.

### Manière de réaliser l'invention

On décrit par la suite plusieurs procédés particuliers de réalisation qui permettent d'obtenir des structures de micro-capacité conformes à l'invention. Certaines étapes du procédé décrit peuvent néanmoins être considérées comme accessoires ou simplement utiles et avantageuses pour améliorer certaines performances, sans être absolument obligatoires pour rester dans le cadre de l'invention.

Ainsi, une micro-capacité conformément à l'invention peut être réalisée sur un micro-composant (1) tel qu'illustré à la figure 1. Le substrat (2) de ce micro-composant comprend en partie supérieure un ou plusieurs niveaux de métallisation (3) qui peuvent être reliés à des zones actives à l'intérieur du micro-composant ou bien encore à des plots d'interconnexion débouchant sur la face supérieure du substrat. Dans la forme illustrée, il s'agit d'un niveau de métallisation situé au niveau de la face supérieure du substrat. Plus précisément, la face supérieure du substrat est recouverte d'une couche de passivation (8), typiquement en SiO₂ ou SiON.

Ainsi, dans la première étape illustrée à la figure 1, on procède au dépôt d'une couche de résine (5) dans laquelle une ouverture (6) est définie par lithographie. Cette ouverture permet de procéder à la gravure localisée de la couche de passivation (8), de manière à laisser apparaître le niveau de métallisation (3) sousjacent. La gravure de la couche de passivation (8) peut, lorsque cette dernière est réalisée en SiON, être effectuée par un procédé classique de gravure chimique utilisant un mélange CF₄:O₂ ou CF₄:H₂ ou bien encore une technique de type "Reactive Ion Etching" (RIE), voire encore en utilisant un plasma radiofréquence.

On procède par la suite à une étape de nettoyage permettant d'éliminer toute trace restante de SiON ou des produits utilisés pour sa gravure. Ce nettoyage peut par exemple être réalisé en utilisant une solution commercialisée sous la référence ACT 970 par la Société ASHLAND. Ce nettoyage peut être suivi d'un pré-rinçage avec dissolution de dioxyde de carbone ou d'ozone par bullage, avec un acide hydroxycarboxylique tel que de l'acide citrique ou encore de l'acide oxalique.

Par la suite, on procède au dépôt d'une couche (10) barrière à la diffusion du cuivre tel qu'illustré à la figure 2. Cette couche barrière à la diffusion sert à améliorer la résistance à l'électro-migration et à la diffusion de l'oxygène . Cette couche peut être déposée par une technique de dépôt de couches atomiques de type ALD (Atomic Layer Deposition). Une telle technique confère une bonne uniformité d'épaisseur et une excellente intégrité à cette couche barrière (10).

Par la suite, on dépose également une couche amorce de cuivre (9) de manière à permettre un dépôt ultérieur par des techniques électrolytiques.

Par la suite, et comme illustré à la figure 3, on procède au dépôt d'une seconde couche de résine (11) qui est ensuite insolée puis éliminée en partie pour définir un logement (12) dont le fond (13) laisse apparaître la couche amorce de cuivre (9).

Par la suite, et comme illustré à la figure 4, on procède à un dépôt électrolytique de cuivre permettant de former la première lamelle large (14) de la première électrode. Le premier dépôt électrolytique s'effectue également jusqu'au contact du niveau de métallisation (3), de manière à connecter électriquement la première électrode au niveau de métallisation par le plot (15).

Par la suite, et comme illustré à la figure 5, on procède à l'élimination des zones de résine (11) définissant le logement qui a permis d'obtenir la première lamelle (14).

Par la suite, deux procédés distincts permettent de définir des structures capacitives d'architectures similaires, mais en utilisant des étapes différentes, et pour des applications également différentes.

### Premier mode de réalisation.

Ainsi, pour réaliser des structures capacitives, utilisées en tant que condensateurs, par exemple de découplage, on procède comme illustré aux figures 6 à 18. A partir de la structure intermédiaire de la figure 5 , et comme illustré à la figure 6, on procède au dépôt d'une résine (16), puis à sa gravure par lithographie pour définir un logement (17) correspondant au tronc central de la première électrode. Par exemple, on peut utiliser la résine du fabricant Clariant AZ4620, ayant des spécificités pour résister aux bains acides de sels de cuivre.

Par la suite, et comme illustré à la figure 7, on procède à un dépôt électrolytique de cuivre, qui s'effectue au-dessus de la zone apparente de la première lamelle (14) également en cuivre pour former le tronçon central (18).

Par la suite, et comme illustré à la figure 8, la résine (16) est éliminée pour laisser apparente la face supérieure de la première lamelle (14) et le premier tronçon central (18).

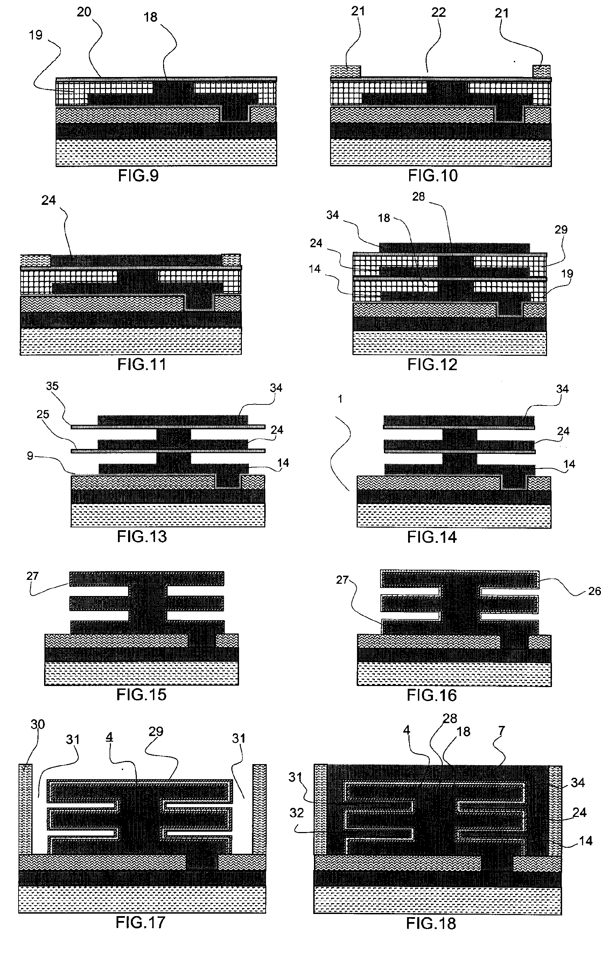

Par la suite, et comme illustré à la figure 9, on procède au dépôt d'un matériau polymère (19), typiquement du polyimide ou du BenzoCycloButene. Ce matériau polymère est déposé par des techniques de dépôt par rotation, également appelées "spin-on deposition". Cette couche polymérique (19) est ensuite planarisée par exemple par CMP. Ce dépôt est planarisé de manière à affleurer sur la face supérieure du premier tronçon central et de manière à laisser apparente cette face pour recevoir, comme illustré à la figure 9, le dépôt d'une couche (20) de TiCu, d'une épaisseur de l'ordre de 200Å. Cette couche sert à la fois de couche de protection pour la couche polymérique (19), ainsi que de couche amorce de cuivre.

Par la suite, et comme illustré à la figure 10, on effectue le dépôt d'une couche de résine (21). Cette couche de résine est ensuite éliminée dans une zone permettant de définir un logement (22) pour le dépôt d'une seconde lamelle de cuivre (24), comme illustrée en figure 11, qui est obtenue par des techniques électrolytiques.

Les différentes étapes de dépôt des lamelles (14,24,34), des tronçons centraux (18,28) et de la couche polymérique (19,29) sont répétées pour aboutir jusqu'à une structure telle qu'illustrée à la figure 12. Bien entendu, le nombre de lamelles illustrées à la figure 12 n'est qu'indicatif, et il est possible de réaliser des structures comportant un nombre de lamelles plus important.

On procède ensuite à l'élimination des couches de résine ayant permis de définir la lamelle supérieure (34) de la première électrode.

Par la suite, et comme illustré à la figure 13, on procède à l'élimination des différentes couches polymériques (19,29). Cette élimination s'effectue par différentes techniques et notamment par des procédés couramment connus sous le terme de "ashing", en utilisant par exemple des plasmas à oxygène, en combinaison avec des composition chimiques appropriées. Il est possible, mais pas obligatoire de procéder par la suite à un traitement thermique de recuit. Ce traitement peut être effectué par lots, à une température voisine de 120°C pendant 30 minutes environ. Il est également possible de procéder à une étape de recuit rapide (RTP).

Après élimination des matériaux polymériques, la structure obtenue présente les restes des couches amorce de cuivre (9,25,35) qui avaient été déposées successivement, et qui sont situées au niveau inférieur de chaque lamelle (14,24,34).

Ces différentes excroissances de couche amorce sont éliminées, comme illustré à la figure 14, par une gravure sélective du cuivre. La solution utilisée pour la gravure peut par exemple être à base d'ammonium persulfate (APS) à pH acide, employée à 45°C. La sélectivité importante (de l'ordre de 1:50) de cette gravure résulte notamment du fait que la structure cristalline de la couche amorce (9,25,35) diffère de celle des lamelles de cuivre (14,24,34) déposées par voie électrolytique. Après ce traitement chimique, on procède par la suite à un traitement thermique de recuit permettant d'homogénéiser la structure du cuivre, notamment entre les différents résidus des couches amorce, présents sous les faces inférieures des lamelles, et le reste des lamelles de cuivre. Ce recuit peut être réalisé sous Hydrogène et Argon à 400°C environ, pendant environ 6 heures.

Par la suite, on procède, comme illustré à la figure 15, au dépôt par ALD d'une couche (27) barrière à la diffusion de l'oxygène, comme expliqué précédemment. Cette couche (27) barrière à la diffusion fait également office de couche amorce pour le dépôt des couches supérieures.

Par la suite, comme illustré à la figure 16, on procède au dépôt d'une couche diélectrique constituée d'une structure nanolaminée (26).

Plus précisément, la structure nanolaminée déposée est réalisée à partir de différentes couches d'oxydes ferroélectriques ou pyroélectriques. Dans un premier exemple particulier de réalisation, la structure nanolaminée (26) peut comporter un empilement de huit couches différentes.
- La première couche, possédant une épaisseur de 5 à 10 Å est réalisée à partir de AlₓO₃₋ₓ, avec x compris entre 0 et 3.
- La seconde couche présente une épaisseur de l'ordre de 10 à 15 Å, et est réalisée à partir de Ta_{z-2}O_{5-z}Al₂Oₓ ,avec z compris entre 0 et 2.
- La troisième couche d'une épaisseur de l'ordre de 15 à 20 Å réalisée à partir de TiO₂Alₓ O_{3+y} , avec y compris entre 0 et 3.
- La quatrième couche d'une épaisseur de l'ordre de 40 à 100 Å est réalisée à partir de TiO_{y-x}Ta_{z-2}O_{5+z}.
- La cinquième couche, d'une épaisseur de 60 à 200 Å est réalisée à partir de TiO_{y}Ta_{3-z}O_{z}.
- Les sixième, septième et huitième couches sont identiques respectivement aux troisième, deuxième et première couches.

La structure nanolaminée ainsi obtenue présente une épaisseur comprise entre 200 et 400 Å . La permittivité relative de cette couche est de l'ordre de 23.

Dans un second exemple de réalisation, la structure nanolaminée (26) peut comporter un empilement de cinq couches différentes, présentant une épaisseur d'au moins 3 couches atomiques.
- La première couche, possédant une épaisseur de 5 à 10 Å est réalisée à partir de Hf_{y}Al_{z}O₃₋ₓ, avec x compris entre 0 et 3, y compris entre 0 et 2 et z compris entre 1 et 10.
- La seconde couche présente une épaisseur de l'ordre de 4 à 15 Å, et est réalisée à partir de Hf_{y+n}Al_{z}O₃₋ₓ ,avec z compris entre 0 et 2, x compris entre 1+n et 3+n, y compris entre 1+n et 2+n et n étant compris entre 1 et 8.
- La troisieme couche présente une épaisseur de l'ordre de 4 à 20 Å, et est réalisée à partir de Hf_{y+2n}Al_{z-n}O₃₋ₓ ,avec z compris entre 0 et 2, x compris entre 1+n et 3+n, y compris entre 1+n et 2+n et n étant compris entre 1 et 8
- La quatrième couche présente une épaisseur de l'ordre de 4 à 15 Å, et est réalisée à partir de Hf_{y+n}Al_{z}O₃₋ₓ ,avec z compris entre 0 et 2, x compris entre 1+n et 3+n, y compris entre 1+n et 2+n et n étant compris entre 1 et 8
- La cinquième couche, possédant une épaisseur de 5 à 10 Å est réalisée à partir de Hf_{y}Al_{z}O₃₋ₓ, avec x compris entre 0 et 3 et y compris entre 0 et 2 et z compris entre 1 et 10.

La structure nanolaminée ainsi obtenue présente une épaisseur comprise entre 20 et 200 Å . La permittivité relative de cette couche est de l'ordre de 18.

Bien entendu, les structures nanolaminée décrites ci-avant sont des exemples non limitatifs, dans lesquelles certains éléments peuvent être substitués sans sortir du cadre de l'invention.

Par la suite, on procède, au-dessus de la structure nanolaminée, au dépôt d'une couche (29) barrière à la diffusion de l'oxygène similaire à celle (27) évoquée précédemment.

Par la suite, et comme illustré à la figure 17, on procède au dépôt d'une couche structurante (30), typiquement obtenue en benzocyclobutène (BCB), en polyimide, en Parylène®.

Cette couche structurante (30) est gravée pour définir un logement (31) autour de la première électrode (4).

On procède par la suite au dépôt d'une nouvelle couche amorce sur la surface de la première électrode (4), de manière à permettre par la suite à un dépôt électrolytique pour former une structure damascène, réalisant la seconde électrode (7) telle qu'illustrée à la figure 18.

D'éventuelles étapes supplémentaires de passivation ou de réalisation de surface de connexion sur la seconde électrode peuvent être mises en oeuvre.

A titre d'exemple, la structure de capacité illustrée à la figure 18 peut présenter une capacitance de l'ordre de 100 nanoFarad/mm². Dans ce cas, les lamelles présentent des dimensions de l'ordre du micron à la dizaine de microns.

### Second mode de réalisation.

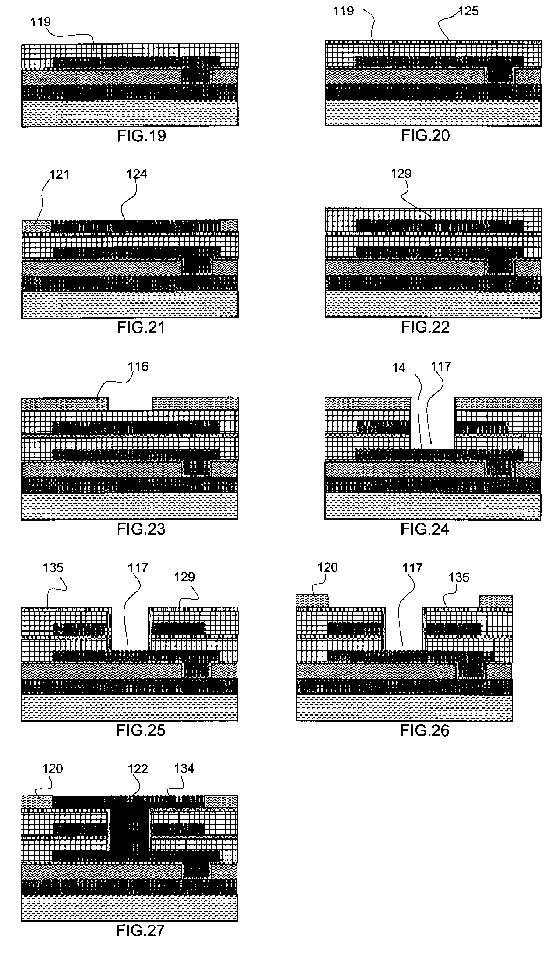

Pour réaliser des structures capacitives, utilisées par exemple en tant que cellules de mémoire vive embarquée (embedded DRAM), on procède à certaines étapes intermédiaires, suite aux opérations permettant d'aboutir à la structure intermédiaire de la figure 5, comme illustré aux figures 19 à 27.

Ainsi, à partir de la structure intermédiaire de la figure 5, et comme illustré à la figure 19, on procède au dépôt d'un matériau polymère (119), tel que déjà décrit en relation avec la figure 9. Ce dépôt est effectué sur une épaisseur correspondant sensiblement à l'espace que l'on souhaite former entre les lamelles successives de la première électrode.

Par la suite, on procède, comme illustré à la figure 20, au dépôt d'une couche (125) de TiCu d'une épaisseur de l'ordre de 200Å. Cette couche sert à la fois de couche de protection pour la couche polymérique (119), ainsi que de couche amorce de cuivre. Cette couche amorce (125) est ensuite planarisée par exemple par CMP.

Par la suite, et comme illustré à la figure 21, on effectue le dépôt d'une couche de résine (121). Cette couche de résine est ensuite éliminée dans une zone permettant de définir un logement pour le dépôt d'une seconde lamelle de cuivre (124), qui est obtenue par des techniques électrolytiques.

On procède par la suite comme illustré à la figure 22, au dépôt d'une nouvelle couche polymérique (129). Les opérations de dépôt d'une couche métallique, et de dépôt d'une couche polymérique peuvent être répétées successivement autant de fois que souhaité. Bien entendu, le nombre de lamelles illustrées à la figure 22 n'est qu'indicatif, et il est possible de réaliser des structures comportant un nombre de lamelles plus important.

Par la suite, on procède comme illustré à la figure 23, au dépôt d'une couche de résine (116). Cette couche de résine est ensuite éliminée dans une zone centrale située à l'aplomb du futur tronc central de la première électrode.

Comme illustré à la figure 24, les couches polymériques (119, 129) et la lamelle métallique (124) sont ensuite gravées pour former une ouverture (117). Cette ouverture (117) laisse apparaître la face supérieure de la première lamelle métallique (14).

Par la suite, et comme illustré à la figure 25, on procède au dépôt d'une couche amorce de cuivre (135), qui recouvre la face supérieure de la couche polymérique (129), et les flancs de l'ouverture (117).

Par la suite, on procède au dépôt d'une couche de résine (120) sur la couche amorce (135), de manière à définir le logement de la future lamelle supérieure de la première électrode, comme illustré à la figure 26.

Par la suite, et comme illustré à la figure 27, on procède au dépôt électrolytique de cuivre de manière à combler le logement (117) et former le tronc central (122) de la première électrode, ainsi que la lamelle supérieure (134).

On procède ensuite à l'élimination des zones de résine (120) ayant permis de définir la lamelle supérieure (134) de la première électrode.

Par la suite, on poursuit le procédé de la même manière que décrit pour le premier mode de réalisation, en relation avec les figures 13 à 18.

Il ressort de ce qui précède que les capacités conformes à l'invention peuvent être obtenues avec des valeurs de capacitance très élevées, sans engendrer de coûts importants en ce qui concerne leur procédé de réalisation.

## Revendications

1. Micro-composant électronique réalisé à partir d'un substrat, et intégrant une structure capacitive réalisée au-dessus d'un niveau de métallisation (3) présent dans le substrat (2), ladite structure capacitive comportant deux électrodes (4,7), **caractérisé en ce que**:
- la première électrode (4) comporte une pluralité de lamelles métalliques (14,24,34 ;124,134) empilées les unes au-dessus des autres, et séparées les unes des autres par des tronçons (18,28) de moindre largeur réalisés à partir du même métal,
- la seconde électrode (7) recouvre la première électrode (4) en comportant une pluralité de lamelles (31,32) intercalées entre les lamelles (14,24,34 ;124,134) de la première électrode (4).

2. Micro-composant selon la revendication 1, **caractérisé en ce que** le métal utilisé présente un résistivité inférieure à 5 µΩ.cm.

3. Micro-composant selon la revendication 1, **caractérisé en ce que** les électrodes (4,7) sont séparées par une couche (26) en un matériau diélectrique choisi dans le groupe des oxydes ferro et/ou pyro-électriques.

4. Micro-composant selon la revendication 3, **caractérisé en ce que** la couche de matériau diélectrique (26), est réalisée par la superposition de couches élémentaires de compositions différentes, formant une structure nanolaminée.

5. Micro-composant selon la revendication 4, **caractérisé en ce que** la stoechiométrie des matériaux varie d'une couche à l'autre de la structure nanolaminée (26).

6. Procédé de réalisation d'une structure capacitive sur un micro-composant électronique, ladite structure capacitive étant réalisée au-dessus du dernier niveau de métallisation (3) apparent présent dans le substrat (2), **caractérisé en ce qu'**il comporte les étapes suivantes, consistant à :
- déposer au-dessus du niveau de métallisation (3) une première couche métallique (14) destinée à former la partie basse d'une des deux électrodes de la structure capacitive,
- déposer au-dessus de ladite première couche métallique une seconde couche métallique (18) de moindre largeur,
- déposer au-dessus de deux couches métalliques (14,18) une couche de matériau polymère (19) dont la face supérieure est apte à servir de support à un dépôt métallique ultérieur,
- répéter les trois étapes de dépôt précédentes de manière à obtenir une structure arborescente formant la première électrode (4) comportant un tronc central et une pluralité de lamelles (14,24,34) s'étendant à partir dudit tronc central,
- éliminer l'ensemble des couches de matériau polymère (19,29),
- déposer sur toute la surface apparente de la première électrode un matériau diélectrique sous forme d'une structure nanolaminée (26),
- déposer par-dessus la première électrode (4) un matériau conducteur venant s'insérer entre les couches métalliques de la première électrode, de manière à former la seconde électrode (7).

7. Procédé de réalisation d'une structure capacitive sur un micro-composant électronique, ladite structure capacitive étant réalisée au-dessus du dernier niveau de métallisation (3) apparent présent dans le substrat (2), **caractérisé en ce qu'**il comporte les étapes suivantes, consistant à :
- déposer au-dessus du niveau de métallisation (3) une première couche métallique (14) destinée à former la partie basse d'une des deux électrodes de la structure capacitive,
- déposer au-dessus de la couche métallique (14) une couche de matériau polymère (119) dont la face supérieure est apte à servir de support à un dépôt métallique ultérieur,
- répéter les deux étapes de dépôt précédentes de manière à obtenir un empilement de couches métalliques séparées par une couche de matériau polymère,
- réaliser au centre de l'empilement une tranchée creusée (117) jusqu'à faire apparaître la première couche métallique (14),
- déposer dans ladite tranchée un métal identique à celui des couches empilées, de manière à obtenir une structure arborescente formant la première électrode (4) comportant un tronc central et une pluralité de lamelles (14, 124, 134) s'étendant à partir dudit tronc central,
- éliminer l'ensemble des couches de matériau polymère (119, 129),
- déposer sur toute la surface apparente de la première électrode un matériau diélectrique sous forme d'une structure nanolaminée (26),
- déposer par-dessus la première électrode (4) un matériau conducteur venant s'insérer entre les couches métalliques de la première électrode, de manière à former la seconde électrode (7).
